# EUROPÄISCHE PATENTSCHRIFT

(11) **EP 2 946 258 B1**
(45) Veröffentlichungstag und Bekanntmachung des Hinweises auf die Patenterteilung: **04.01.2017**
(21) Anmeldenummer: 14706280.6
(22) Anmeldetag: 15.01.2014
(51) Int. Cl.: F24F 11/00, G05D 23/19, H05K 7/20

(54) **VERFAHREN ZUR ANPASSUNG EINES SOLLWERTS FÜR DIE KLIMATISIERUNG EINER IT-UMGEBUNG**
METHOD FOR ADAPTATION OF A DESIRED VALUE FOR CONDITIONING THE AIR OF AN IT ENVIRONMENT
PROCÉDÉ POUR ADAPTER LA VALEUR DE CONSIGNE DE CLIMATISATION D'UNE PIECE D'UN CENTRE DE TRAITEMENT INFORMATIQUE

(30) Priorität: 18.01.2013 DE 102013100524; 07.10.2013 DE 102013111053
(43) Veröffentlichungstag der Anmeldung: 25.11.2015
(73) Patentinhaber: RITTAL GmbH & Co. KG, 35745 Herborn (DE)
(72) Erfinder: NICOLAI, Michael, 35466 Rabenau (DE); NONN, Helmut, 57629 Malberg (DE); SIEGEL, Tim, 35625 Hüttenberg-Rechtenbach (DE)
(74) Vertreter: Angerhausen, Christoph
(86) Internationale Anmeldenummer: PCT/DE2014/100008
(87) Internationale Veröffentlichungsnummer: WO 2014/111087

(56) Entgegenhaltungen:
- DE-A1-102010 031 830
- GB-A- 2 470 475
- US-A- 5 915 473
- Mark Hydeman: "Implications of Current Thermal Guidelines for Data Center Energy Use", ASHRAE Journal - August 2010, 30. August 2010 (2010-08-30), Seiten 30-36, XP055113165, USA Gefunden im Internet: URL:http://www.nxtbook.com/nxtbooks/ashrae /ashraejournal_201008/index.php?startid=30 [gefunden am 2014-04-09]

## Beschreibung

Die Erfindung geht aus von einem Verfahren zum Klimatisieren einer IT-Umgebung, die als Hardware beispielsweise IT-Geräte, Rechner, Speicher, Telekommunikationsgeräte und Peripheriegeräte umfasst, wobei in einem Kälteversorgungssystem Kältemaschinen und gegebenenfalls Freikühler und ein mit Lüftern betriebenes und Wärmetauscher enthaltendes Umluftsystem zum Abführen der von der Hardware und weiteren Komponenten des Rechenzentrums erzeugten Wärme vorhanden sind, wobei das Verfahren die Schritte aufweist: Klimatisieren der IT-Umgebung mit dem Kälteversorgungssystem, das der IT-Urngebung über das Umluftsystem Luft mit einer Zulufttemperatur zuführt; Festlegen eines Basis-Sollwertes für die Zulufttemperatur zur IT-Umgebung aufgrund der bestehenden Hardware-Konfiguration; ständiges Messen der elektrischen Leistungsaufnahme der Hardware und Speichern eines dabei jeweils gemessenen Wertes; und Ermitteln eines Sollwertes für die Zulufttemperatur aus dem gemessenen Wert für die elektrische Leistungsaufnahme der Hardware. Ein derartiges Verfahren ist aus der US 5,915,473 A bekannt, bei dem ein Basis-Sollwert für eine zu regelnde Größe, beispielsweise die Lufttemperatur, festgelegt wird. Es wird ein Parameter gemessen, nämlich der Wert für die Feuchtigkeit, der eine Störgröße repräsentiert, die einen direkten oder indirekten Einfluss auf die Lufttemperatur hat.

Die Erfindung ist auch für Industrie-Anwendungen geeignet und auf weitere Anwendungsfälle übertragbar, beispielsweise die Raumklimatisierung.

Als IT-Umgebung sollen Systeme jedweder Größe verstanden werden, die zumindest teilweise die oben genannte Hardware enthalten. Eine IT-Umgebung kann beispielsweise als Schaltschrank realisiert sein, als Anordnung von Schaltschränken oder als größere Einheit, bis hin zu einem Rechenzentrum.

Klimatisierungsverfahren bzw. Klimageräte werden in der Regel dazu verwendet, die Temperatur der Umgebungsluft oder eines anderen Kühlmediums auf einem jeweils bestimmten Sollwert zu halten. Dies ist erforderlich, wenn ohne Klimatisierungsmaßnahmen zulässige Grenzwerte der Temperatur über- oder unterschritten würden.

Ein großer Teil des Stromverbrauchs in einer IT-Umgebung entfällt somit auf die Kühlung, so dass hier ein optimal angepasstes System zur Kostensenkung beitragen kann. Tatsächlich werden 25 % bis 60 % des Energiebedarfs für die Klimatisierung aufgewandt, wobei die niedrigen Werte nur mit freier Kühlung erreichbar sind. Dabei ist der größte Energieverbraucher der Kompressor im Klimagerät, der daher nur dann eingesetzt werden sollte, wenn die Außentemperatur höher ist als die Temperatur in der IT-Umgebung.

Die American Society of Heating, Refrigerating and Air-Conditioning Engineers (ASHRAE) fasst in ihrem jährlich neu erscheinenden Handbuch Entwicklungen und Trends zusammen und gibt Empfehlungen für eine klimaeffiziente Gestaltung von IT-Umgebungen, die die freie Kühlung in den Vordergrund stellen. Dabei werden auch Richtlinien für als unkritisch angesehene Zulufttemperaturen für Server angegeben, die sogar kurzfristig überschritten werden dürfen. Eine Zusammenfassung ist in www.datacenterjournal.com/facilities/ashraeguidelines-enable-years-round-free-cooling/ zu finden.

Weiteres zu den Richtlinien findet sich in Mark Hydeman: "Implications of Current Thermal Guidelines for Data Cnter Energy Use", ASHRAE Journal - August 2010, 30. August 2010, Seiten 30-36, XP055113165, USA.

Herkömmliche Klimatisierungsverfahren nutzen die Zulufttemperatur für die Server als Parameter für die Regelung, wobei auf einen konstanten Sollwert für die Zulufttemperatur abgestellt wird. Als Beispiel sei das System "LCP Inline" angegeben, das im Handbuch 33, Ausgabe 2011/2012, Seiten 462, 463, der Rittal GmbH & Co. KG beschrieben ist. Hier wird durch eine stufenlose Anpassung des Luftvolumenstroms aufgrund der Temperaturdifferenz von Zuluft und Rückluft am Server für die konstante Serverzulufttemperatur gesorgt. Damit wird für die Regelung der Klimatisierung die durch diverse Prozesse hervorgerufene Temperaturveränderung herangezogen. Da Erwärmungsvorgänge relativ langsam ablaufen, kann eine so gestaltete Regelung der Klimatisierung ebenfalls nur langsam folgen.

Die GB 2,470,475 A befasst sich ebenfalls mit der Klimatisierung eines Raumes oder Rechenzentrums, in dem eine IT-Ausrüstung untergebracht ist, wobei die Lufttemperatur detektiert und diese Temperatur basierend auf einer vorbestimmten Temperatur gesteuert wird, die den Energieverbrauch der Klimaanlage und der IT-Ausrüstung zusammen minimiert.

Es ist die Aufgabe der vorliegenden Erfindung, ein Verfahren zum Klimatisieren einer IT-Umgebung, einer Industrie-Umgebung oder eines Raumes zur Verfügung zu stellen, das schnell auf Änderungen der Betriebsbedingungen reagiert und bei dem, wenn vorhanden, der Anteil der Freikühlung unter Einhaltung der ASHRAE-Empfehlungen für die Zulufttemperatur zur Hardware oder eines anderen Wärmeerzeugers so hoch wie möglich ist.

Dies kann insbesondere dann erreicht werden, wenn die Grenztemperatur für das Freikühlen so hoch wie möglich angesetzt werden kann.

Die Aufgabe wird durch ein Verfahren nach Anspruch 1 gelöst. Vorteilhafte Ausgestaltungen sind Gegenstand der Unteransprüche.

Das erfindungsgemäße Verfahren zeichnet sich durch die folgenden Schritte aus: Anheben des Basis-Sollwertes für die Zulufttemperatur, solange keine Änderung des Wertes für die elektrische Leistungsaufnahme der Hardware ermittelt wird; bei Detektion eines Anstiegs des Wertes für die elektrische Leistungsaufnahme der Hardware auf einen kritischen Wert, Absenken des angehobenen Basis-Sollwertes für die Zulufttemperatur bis der gespeicherte Wert wieder erreicht wird; und, wenn der gespeicherte Wert innerhalb einer zuvor festgelegten Zeitdauer nicht erreicht wird, Rücksetzen des Sollwertes für die Zulufttemperatur auf den Basis-Sollwert.

Die Erfindung nutzt jetzt die Ursache einer Temperaturveränderung zum Regeln der Klimatisierung. Ursache einer Temperaturveränderung, also Störgröße, ist dabei die Zufuhr oder Entnahme von Energie, beispielsweise in Form von elektrischer Verlustleistung, elektrische Leistungsaufnahme der Hardware, Wärmeeinstrahlung von außen, Auslastung von wärmeproduzierenden Anlagen, passive Wärmeübertragung durch Temperaturdifferenzen, Volumenstrom von Kühlmedien oder wärmetransportierenden Stoffen und dergleichen.

Die Erfindung macht sich weiter die Erkenntnis zunutze, dass die Leistungsaufnahme der Hardware im Wesentlichen die Anhebung der Solltemperatur für die Zuluft festlegt und damit die Solltemperatur für den Vorlauf der Wärmetauscher mit angehoben wird, was zu einer höheren Grenztemperatur für das Freikühlen führt. Im Allgemeinen ist direkte Freikühlung möglich, wenn die Außentemperatur unterhalb von 22 °C liegt, indirekte Freikühlung erfordert Temperaturen von 13 °C oder niedriger. Die Grenztemperaturen können angehoben werden, wenn, wie erfindungsgemäß vorgesehen ist, die elektrische Leistungsaufnahme der Hardware als Führungsgröße für die Regelung eingesetzt wird. Ein kritischer Parameterwert ist dabei durch einen - gegebenenfalls toleranzbehafteten - Anstieg der elektrischen Leistungsaufnahme der Hardware definiert.

Um den ASHRAE-Empfehlungen zu genügen, wird bei der vorliegenden Erfindung ein aktuell maximal möglicher Sollwert für die Zulufttemperatur ermittelt, wobei aber hier dann, wenn ein Anstieg der elektrischen Leistungsaufnahme der Hardware gemessen wird, der Sollwert für die Zulufttemperatur wieder abgesenkt wird, bis der gespeicherte Wert der elektrischen Leistungsaufnahme der Hardware wieder erreicht ist.

Vorteilhaft werden folgende Schritte durchgeführt:
- Messen der Zulufttemperatur zur Hardware;
- Messen der Rücklufttemperatur von der Hardware;
- Ermitteln des Sollwertes der Drehzahl für die Lüfter des Umluftsystems mit der Zulufttemperatur und der Rücklufttemperatur als Parameter;
- Messen des Istwertes der Drehzahl der Lüfter des Umluftsystems;
- Erhöhen oder Erniedrigen der Drehzahl, um Sollwert und Istwert aneinander anzugleichen, so dass ein aktualisierter Istwert erhalten wird.

Mit dieser Maßnahme wird sichergestellt, dass das Einhalten des Sollwertes für die Zulufttemperatur vorrangig über die energieeffizient zu betreibenden Lüfter des Umluftsystems erfolgt.

Weiter vorteilhaft werden alle Lüfter des Umluftsystems parallel mit einem Signal angesteuert.

Nach einer Variante des erfindungsgemäßen Verfahrens wird der Sollwert der Vorlauftemperatur der Wärmetauscher aus dem Istwert der Zulufttemperatur ermittelt.

Insbesondere kann vorgesehen sein, dass die Vorlauftemperatur der Wärmetauscher als Stellgröße für die Drehzahl der Lüfter des Freikühlers verwendet wird.

Nach einem weiteren Aspekt der Erfindung wird in regelmäßigen oder unregelmäßigen Abständen geprüft, ob gemessene Parameterwerte zur Verfügung stehen, die mit aktuell wirkenden Störgrößen zu korrelieren sind.

Die Auswerte-Einheit prüft dazu in regelmäßigen oder unregelmäßigen Abständen, ob in ihren Eingangs-Schnittstellen Messdaten zur Verfügung stehen, die Aufschluss über die aktuell wirksamen Störgrößen geben.

Stehen keine gültigen Messwerte zur Verfügung, wird der Ausgang des Reglers als Stellgröße verwendet. Das entspricht einer klassischen Temperaturregelung ohne Einfluss einer übergeordneten Auswerte-Einheit.

Stehen ausreichend Messwerte zur Verfügung, um abzuleiten, dass bei entsprechender Einstellung der Stellgröße eine Überschreitung des vorgegebenen Sollwerts durch die aktuelle Temperatur nicht möglich ist, wird als Stellgröße ein aus Konditionierung der gemessenen Parameterwerte gewonnener Wert verwendet. Das entspricht einer direkten Steuerung der Klimatisierungsmaßnahme durch die Auswerte-Einheit ohne geschlossenen Regelkreis.

Stehen Messwerte zur Verfügung, die jedoch nicht ausreichen, um durch direkte Vorgabe der Stellgröße eine Nicht-Überschreitung des Sollwerts zu garantieren, wird der Ausgang des Reglers mit einem aus Konditionierung der Messwerte gewonnenen Korrektur-Wert beaufschlagt.

Im Folgenden soll die Erfindung lediglich beispielhaft anhand der beigefügten Zeichnung erläutert werden. Dabei zeigt:
- Figur 1: den grundlegenden Aufbau eines hydraulischen Systems zur Kälteversorgung einer IT-Umgebung;
- Figur 2: den grundlegenden Aufbau einer beispielhaften IT-Umgebung;
- Figur 3a: eine schematische Ansicht der Hydraulikstation einer Kältestation;
- Figur 3b: eine Seitenansicht einer Kältestation;
- Figur 3c: eine Ansicht der Kältestation zur Veranschaulichung der Anordnung der Freikühler;
- Figur 3d: schematisch die eingehausten Kältemaschinen;
- Figur 4: eine schematische Darstellung der Parameterführung bei der vorliegenden Erfindung;
- Figur 5: die entsprechende Prozessführung bei der optimierten Regelung;
- Figur 6a: eine Darstellung der Regelkreise für die Ermittlung der Lüfterdrehzahl der Lüfter im Umluftkühlsystem sowie des Sollwertes der Zulufttemperatur,
- Figur 6b: eine Darstellung der Regelkreise, mit denen sichergestellt werden soll, dass eine optimale Klimaregelung erfolgt, und
- Figur 7: eine schematische Darstellung der Kälteversorgung nach einem weiteren Aspekt, der nicht Gegenstand der Erfindung ist.

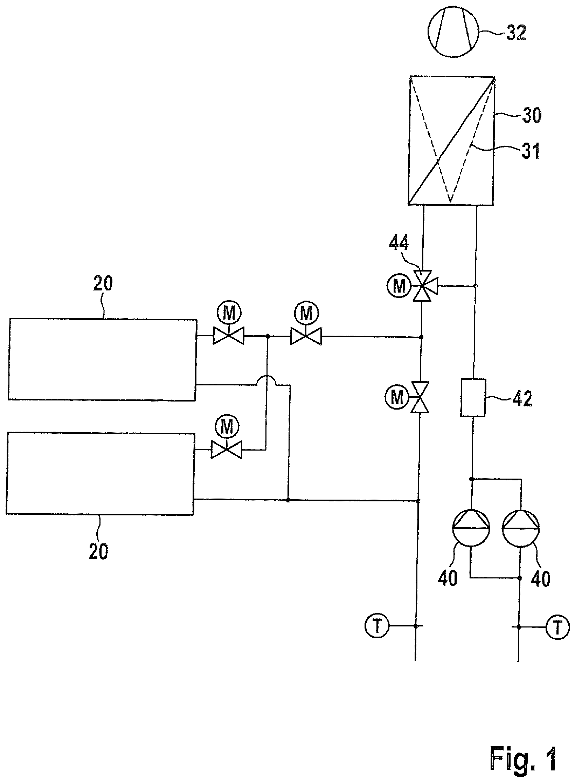

Figur 1 zeigt den grundlegenden Aufbau eines hydraulischen Systems zur Kälteversorgung einer IT-Umgebung. Bei derartigen Systemen wird im Allgemeinen eine n + 1-Redundanz realisiert. Im vorliegenden Fall sind zwei Kältemaschinen 20 vorgesehen, die beispielsweise Kompressoren enthalten, sowie ein nicht redundant ausgelegter Freikühler 30, dem ein EC-Ventilator 32 nachgeschaltet ist. Ein in V-Form ausgeführter Wärmetauscher 31 des Freikühlers 30 (strichliert dargestellt) bietet dabei bezogen auf den zur Verfügung stehenden Bauraum eine maximale Wärmetauscherfläche. Zwei drehzahlregelbare Pumpen 40, die wiederum in n + 1-Redundanz arbeiten, fördern das Kühlmedium durch die Kältemaschinen 20 beziehungsweise den Freikühler 30. Es ist vorgesehen, die Kältemaschinen 20 hydraulisch zu umgehen, wenn die erforderliche Kälteleistung durch den Freikühler 30 erzeugt werden kann. Bei der hydraulischen Umgehung wird eine Bypassleitung freigegeben, wobei zur fluidischen Steuerung motorbetriebene Klappen M beziehungsweise ein Dreiwege-Ventil 44 eingesetzt werden, die den Strömungsweg nicht einengen. Neben einem Strömungsmesser 42 sind Sensoren T für die Temperatur vorhanden.

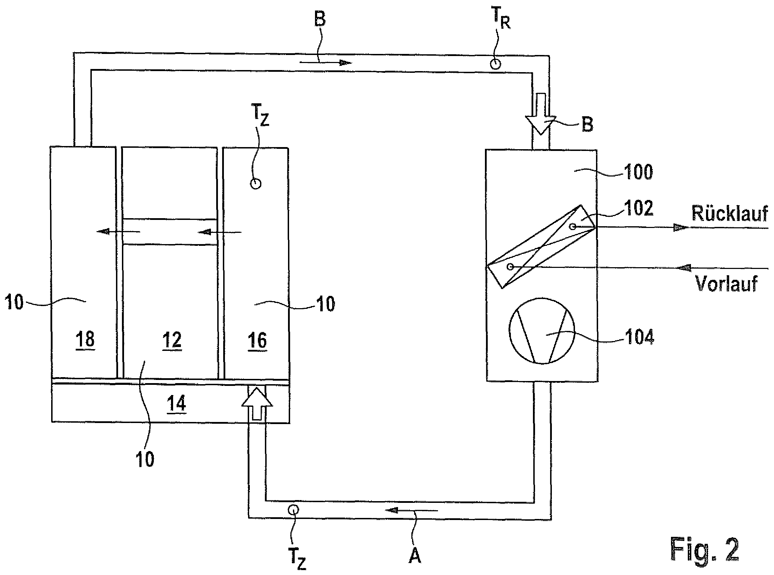

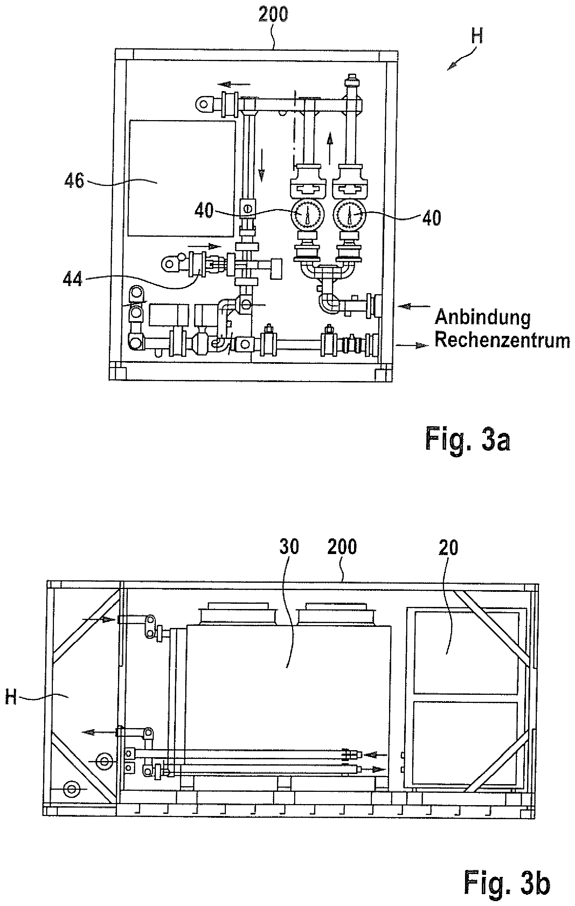

Mit einem solchen System kann das erfindungsgemäße Verfahren nach Anspruch 1 realisiert werden. Das System kann dabei einerseits Bestandteil der IT-Umgebung sein, wie im Zusammenhang mit Figur 2 erläutert, aber auch ein eigenständiges Modul. Damit können zum Beispiel Rechenzentrumsumgebungen, die nicht an eine kundenseitige Kälteversorgung angebunden werden können, autark durch Einsatz einer betriebsfertig ausgelieferten Kältestation mit Kälte zur Kühlung der Hardware versorgt werden. Eine beispielhafte Kältestation ist schematisch in den Figuren 3a bis 3d dargestellt.

Figur 2 zeigt den grundlegenden Aufbau einer beispielhaften IT-Umgebung mit integrierter Kälteversorgung mitsamt den Komponenten für die Klimatisierung. In einer Einhausung 10 ist die Hardware der IT-Umgebung untergebracht, im Regelfall in Racks 12, die auf einem Doppelboden 14 aufgestellt sind. Klimatechnisch wird der Raum um die Racks 12 herum in einen Kaltgang 16 und einen Warmgang 18 aufgeteilt. Kalte Zuluft, symbolisiert durch den Pfeil A, tritt durch eine Gitterstruktur aus dem Doppelboden 14 in den Kaltgang 16 und wird durch die Racks 12 gefördert, wo sie Wärme, die von der Hardware erzeugt wird, aufnimmt, und in den Warmgang 18 transportiert. Die Rückluft, symbolisiert durch den Pfeil B, tritt in ein Umluftkühlgerät 100 ein und wird dort abgekühlt, wobei die Kühlung mittels eines Wärmetauschers 102 erfolgt. Die gekühlte Luft wird durch den Ventilator 104 wieder in die Einhausung 10 gefördert. Im vorliegenden Fall wird der Wert der Zulufttemperatur durch zwei Sensoren T_{Z} erfasst, die im Kaltbereich angeordnet sind, nämlich im Kaltgang 16 beziehungsweise in einer Zuluftleitung zum Doppelboden 14. Die Temperatur der Rückluft wird entsprechend durch einen Sensor T_{R} vor dem Eintritt in das Umluftkühlgerät 100 erfasst. Weitere Sensoren T_{z} und T_{R} können vorgesehen sein, um eine Anzahl von Messungen für die Temperatur zu erfassen, die dann entsprechend bestimmter Vorgaben, die weiter oben schon angesprochen sind, konditioniert werden.

Die Kältestation als eigenständiges Modul, das beispielsweise in einer Stahlrahmenkonstruktion montiert ist, im Allgemeinen mit 200 bezeichnet, ist in den Figuren 3a bis 3d gezeigt. Bevorzugt werden als Abmaße die eines ISO-Containers gewählt, so dass die Kältestation mit genormten Fahrzeugen transportierbar ist.

Figur 3a zeigt eine Hydraulikstation H mit redundanten Pumpen 40, Regelventilen, z.B. 44, Flowmetern usw. und einer Steuerung 46, die in einem Schaltschrank oder zwei Schaltschränken (nicht dargestellt) untergebracht ist. Somit kann mit der Regelung des Rechenzentrums derart kommuniziert werden, dass Vorlauftemperatur und Wassermenge nach den Betriebsbedingungen innerhalb des Rechenzentrums (oder einer anderen IT-Umgebung) automatisch nachgeführt werden. Dabei sollte die Steuerung 46 der Kältestation so aufgebaut werden, dass diese regelungsseitige Verknüpfung im Rahmen der Inbetriebnahme nur aktiviert werden muss, wenn ein Komplettpaket aus IT-Umgebung und Kältestation zum Einsatz kommt. Die Kältestation ist damit bei entsprechender Auslegung von Kältemaschinen und Freikühler in der Leistung auf die jeweilige Baugröße des Rechenzentrums abstimmbar.

Figur 3b zeigt eine Seitenansicht einer Kältestation, in der schematisch die schon beschriebene Hydraulikstation H, eine Freikühleranordnung 30 und Kältemaschinen 20 veranschaulicht sind.

Die Kältestation umfasst zwei oder mehr Kältemaschinen 20, es wird damit eine n + 1-Redundanz realisiert. Die Kältemaschinen 20 sind beispielsweise als luftgekühlte Kältemaschinen aufgebaut und haben eine an die bevorzugt kompaktere Raumsituation angepasste Geometrie, um einen möglichst kleinen Footprint zu erzeugen. Dies kann beispielsweise dadurch erreicht werden, dass der Bauraum für die Kältekomponenten in die Höhe, zum Beispiel als Säulenform, realisiert wird. Die Kältemaschinen 20 werden zur Optimierung der Energie-Effizienz mit elektronischen Expansionsventilen ausgestattet und können zu diesem Zweck ebenfalls drehzahlgeregelte Kompressoren enthalten.

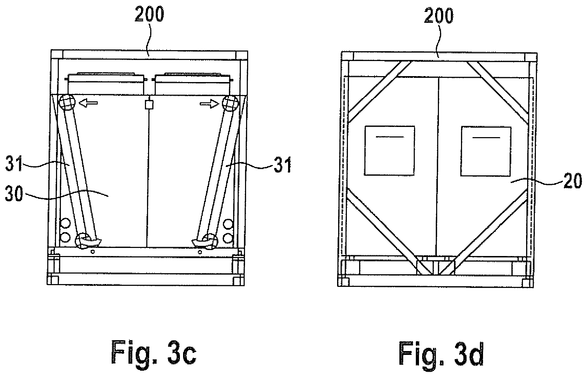

Um eine energieoptimierte Freikühlung zu erreichen, beinhaltet die Kältestation, wie in Figur 3c gezeigt, einen Freikühler 30, der, bezogen auf den verfügbaren Bauraum, eine in V-Form ausgeführte maximale Fläche des Wärmetauschers 31 bietet. Es ist eine Ausstattung mit EC-Ventilatoren (z. B. 32 in Fig. 1) vorgesehen, um die Freikühlleistung auch in jahreszeitlichen Übergangszeiten stetig der erforderlichen Kühlleistung anzupassen.

Als weitere Kälteerzeuger sind Kältemaschinen 20 vorgesehen, die wiederum lediglich schematisch in Figur 3d gezeigt sind. Die Komponenten der Hydraulikstation H dienen nun dazu, das Kühlmedium durch die Kältemaschinen 20 und letztlich an das angebundene Rechenzentrum zu fördern. Es ist vorgesehen, die Kältemaschinen 20 hydraulisch zu umgehen, wenn die erforderliche Kälteleistung durch den Freikühler 30 erzeugt werden kann. Bei der hydraulischen Umgehung wird eine Bypass-Leitung freigegeben, zur Mediensteuerung werden motorbetriebene Klappen eingesetzt, die den Strömungsweg nicht einengen.

Das Leitungssystem besteht aus Polypropylen und ist damit absolut korrosionsbeständig. Bedingt durch die Wandstärke und die isolierende Wirkung des verwendeten Kunststoffmaterials kann in der Regel auf den Einsatz einer thermischen Isolierung verzichtet werden. Versuche haben gezeigt, dass das Leitungssystem mit einer Medientemperatur von minimal 10 °C betrieben werden kann, ohne dass Kondensat an den Leitungsoberflächen entsteht.

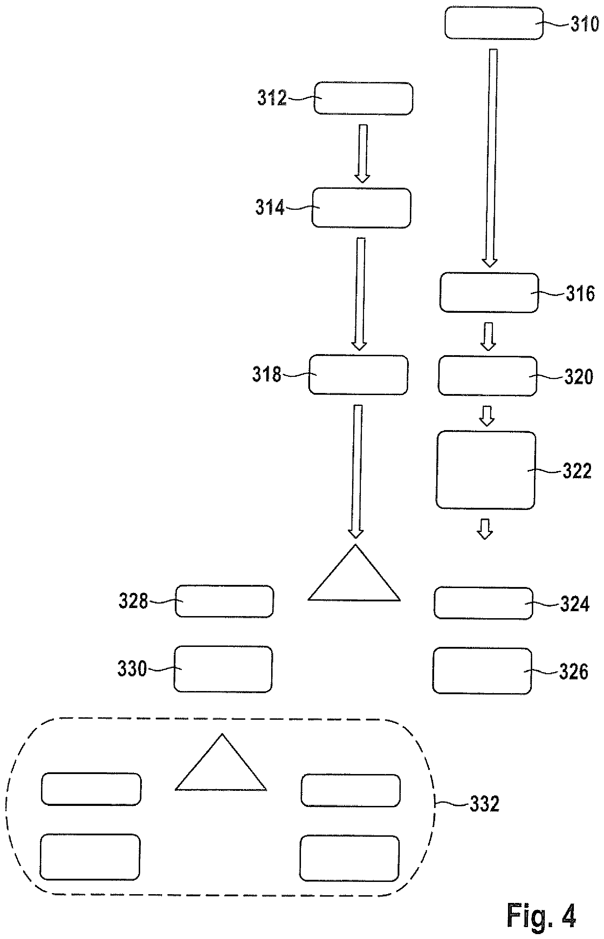

Figur 4 zeigt eine schematische Darstellung der Parameterführung bei dem ersten Aspekt gemäß der vorliegenden Erfindung. Vor Beginn des gesamten Optimierungsprozesses wird ein Betrag für den Sollwert der Zulufttemperatur festgelegt und gespeichert 310. Erfindungsgemäß wird die Anhebung der Zulufttemperatur ausschließlich von der elektrischen Leistungsaufnahme der Hardware abhängig gemacht. Daher wird diese ständig gemessen 312, damit eine Detektion auf einen Anstieg 314 der elektrischen Leistungsausnahme erfolgen kann. Solange kein Anstieg 314 erfasst wird, wird der Sollwert der Zulufttemperatur erhöht, nach einer bevorzugten Ausführungsform der Erfindung gemäß einer linearen Funktion.

Sobald eine Erhöhung der elektrischen Leistungsaufnahme festgestellt wird 318, wird die Erhöhung des Sollwertes der Zulufttemperatur gestoppt 320. Es erfolgt eine Absenkung 322 des Sollwertes der Zulufttemperatur auf den Betrag, der bei der Detektion des Anstiegs der elektrischen Leistungsaufnahme vorlag. Zunächst wird davon ausgegangen, dass dieser Zustand die aktuell maximal mögliche Zulufttemperatur darstellt. Durch einen parametrierbaren Offset kann zusätzlich sichergestellt werden, dass die Schaltschwelle der Hardware immer unterschritten wird. Wenn im Anschluss hieran die elektrische Leistungsaufnahme fällt 324, wird der Sollwert der Zulufttemperatur bis zum nächsten Optimierungsprozess beibehalten 326. Fällt die elektrische Leistungsaufnahme hingegen nicht 328, kann dies in einer stärkeren Belastung der Hardware, beispielsweise durch Auslastung der CPUs begründet sein. Um sicherzustellen, dass die höhere Leistungsaufnahme nicht von einer immer noch zu hohen Zulufttemperatur hervor gerufen wird, wird im Anschluss eine Absenkung 330 des Sollwertes der Zulufttemperatur auf den Wert vor Beginn des gesamten Optimierungsprozesses, der ja gespeichert worden ist, vorgenommen. Steigt die elektrische Leistungsaufnahme der Hardware außerhalb des Optimierungszeitfensters, wenn also keine Änderung der Zulufttemperatur aktiv ist, so gibt dies an, dass eventuell eine zusätzliche Hardwarebestückung vorgenommen worden ist oder eine temporär stärkere Auslastung der Hardware vorliegt. Eine Detektion des Ansteigens der elektrischen Leistungsaufnahme der Hardware außerhalb des Optimierungszeitfensters 332 führt zu keiner Veränderung des Sollwertes der Zulufttemperatur.

Der beschriebene Regelkreis gemäß der vorliegenden Erfindung wird im Rahmen eines Zeitprogramms wiederkehrend in einem freigegebenen Zeitraum aktiv. Die Startzeiten und der Zeitraum sind frei parametrierbar.

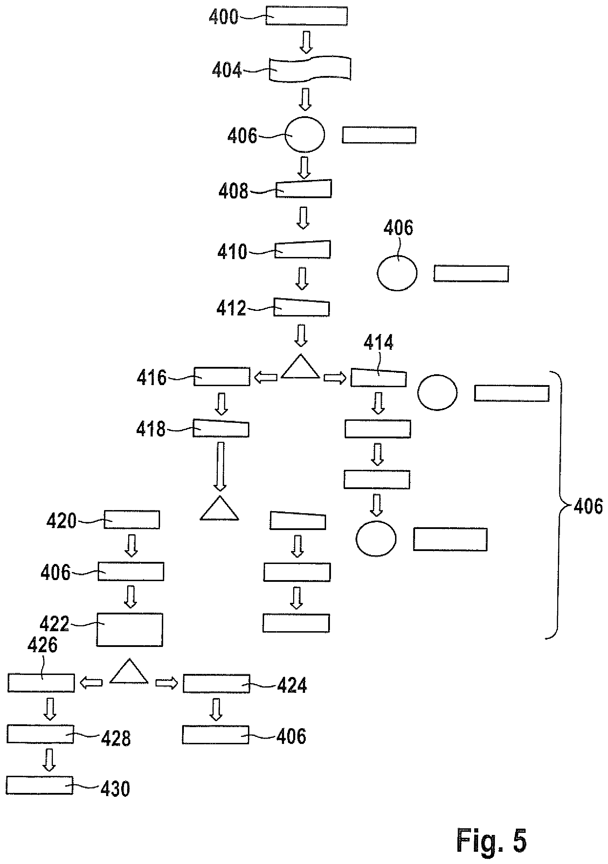

In Figur 5 ist die entsprechende Prozessführung angegeben. Zunächst erfolgt die Parametrierung 402 mit Sollwerten, insbesondere mit dem Basis-Sollwert für die Zulufttemperatur. Die Messwerte für die elektrische Leistungsaufnahme der Hardware werden in vorgegebenen Intervallen eingelesen 404. Entsprechend der gewählten Parametrierung der Zeitfunktion wird dann der Optimierungsprozess gestartet 406. Dabei erfolgt, wie bereits beschrieben, die Anhebung 408 des Sollwertes der Zulufttemperatur, bis ein Anstieg der elektrischen Leistungsaufnahme der Hardware detektiert wird. Der Optimierungsprozess 406 sorgt dann dafür, dass der Sollwert der Zufuhrtemperatur gesenkt wird 412. Erfolgt dann der Abfall der elektrischen Leistungsaufnahme, wird der Optimierungsprozess 406 nach Zeitfunktion beendet und die Zeitfunktion rückgesetzt. Nach Ablauf einer parametrierten Wartezeit wird der Optimierungsprozess 406 erneut gestartet. Fällt die elektrische Leistungsaufnahme hingegen nicht ab 416, wird der Sollwert der Zulufttemperatur weiter abgesenkt 418. Falls dann ein Abfall der elektrischen Leistungsaufnahme detektiert wird 414, wird der Optimierungsprozess 406 nach Zeitfunktion c beendet und die Zeitfunktion anschließend rückgesetzt. Wenn hingegen die elektrische Leistungsaufnahme weiterhin nicht abfällt 420, wird der Optimierungsprozess 406 beendet, und es erfolgt eine Anfrage 422 beim Nutzer, ob die Hardwarebestückung seit dem letzten Abfragezeitpunkt geändert wurde. Falls die Hardwarebestückung geändert wurde 424, wird die Zeitfunktion des Optimierungsprozesses 406 rückgesetzt, so dass entsprechend der parametrierten Startzeiten eine erneute Optimierung erfolgen kann. Falls die Hardwarebestückung jedoch nicht geändert wurde 426, wird die Zeitfunktion verriegelt 428 und eine Störmeldung ausgegeben 430.

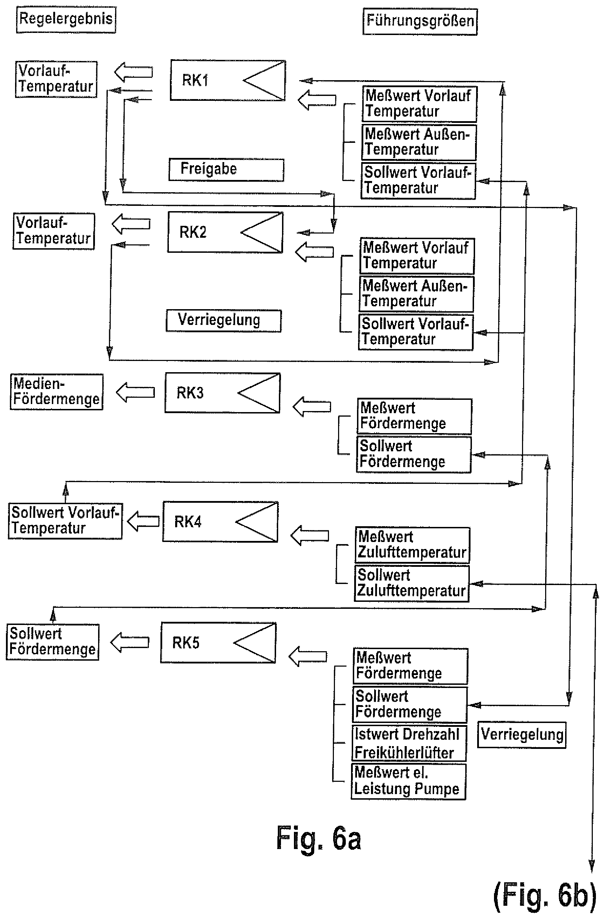

Figur 6a veranschaulicht schematisch, wie der im Optimierprozess ermittelte Sollwert der Zulufttemperatur in die weitere Regelung einfließt. Der eben in Zusammenhang beschriebene Prozessablauf gemäß Figur 5 wird dabei durch den Regelkreis RK7 zusammengefasst.

Die Aufgabe des Regelkreises RK7 ist es, den Sollwert der Zulufttemperatur vorzugsweise auf einen höheren Wert zu verschieben. Durch eine Anhebung des Sollwertes der Zulufttemperatur wird nämlich der Sollwert der Vorlauftemperatur für die Wärmetauscher ebenfalls angehoben, was wiederum die Grenztemperatur für das Freikühlen erhöht. Dabei geht erfindungswesentlich als Führungsgröße die Messung der elektrischen Leistungsaufnahme der Hardware ein. Der optimierte Sollwert für die Zulufttemperatur wird in weiteren Regelprozessen verwendet.

Erfindungsgemäß wird der Sollwert der Zulufttemperatur so lange weiter angehoben, bis die elektrische Leistungsaufnahme der Hardware steigt. Wenn ein Anstieg detektiert wird, erfolgt eine Absenkung des Sollwertes der Zulufttemperatur, bis die elektrische Leistungsaufnahme der Hardware wieder ihren ursprünglich festgestellten Wert eingenommen hat. Dieser Zustand definiert gemäß der vorliegenden Erfindung die aktuell maximal mögliche Zulufttemperatur.

Steigt die elektrische Leistungsaufnahme aus diesem Beharrungszustand an, so ist dies ein Hinweis auf eine zusätzliche Bestückung mit Hardware oder eine temporär stärkere Auslastung der Hardware. Eine Detektion des Ansteigens der elektrischen Leistungsaufnahme der Hardware aus dem Beharrungszustand führt zu einem Rücksetzen des Sollwertes der Zulufttemperatur auf den parametrierten und gespeicherten Betrag.

Im Zuge der Optimierung, was die Energieeffizienz der Klimatisierung betrifft, wird die Zulufttemperatur zunächst bevorzugt über den Betrieb von Lüftern eingestellt, die den zu kühlenden Racks zugeordnet sind. Dazu werden, wie schon erläutert, Mittelwerte der Zulufttemperatur T_{z} und der Rücklufttemperatur T_{R} bestimmt. Wie aus Figur 6a hervorgeht, wird aus den Mittelwerten der Zulufttemperatur und der Rücklufttemperatur eine Temperaturdifferenz errechnet und mit einem Sollwert für die Temperaturdifferenz verglichen. Der Regelkreis RK6 passt dann die Lüfterdrehzahl der Lüfter an. Alle Lüfter werden parallel mit einem Signal angesteuert. Über die Differenztemperaturregelung kann der Sollwert der Zulufttemperatur auch bei Schwankungen der Leistungsaufnahme der Hardware gehalten werden.

Eine nur temporär stärkere Auslastung der Hardware wird nach Abklingen der Lastspitze wieder zu einer Absenkung der Drehzahl der Lüfter führen.

Es wird bei der Erfindung davon abgesehen, die Zulufttemperatur in Abhängigkeit von der Drehzahl der Lüfter anzuheben oder zu senken, da dies wiederum die Differenztemperaturregelung beeinflussen würde. Eine mögliche Anhebung der Zulufttemperatur wird ausschließlich von der elektrischen Leistungsaufnahme der Hardware abhängig gemacht.

Kann die Last z. B. durch eine zusätzliche Bestückung mit Hardware bei dem parametrierten Sollwert für die Zulufttemperatur nicht mehr allein durch eine Erhöhung der Drehzahl der Lüfter abgeführt werden, so wird dies, wie im weiteren erläutert wird, automatisch abgefangen.

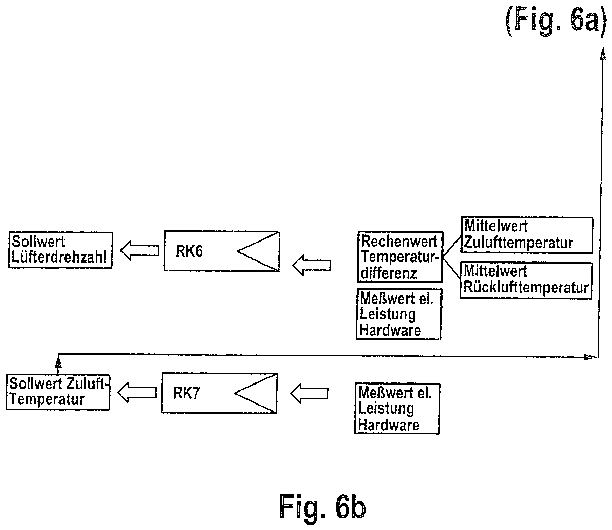

Der optimierte, aktuell maximal mögliche Sollwert der Zulufttemperatur wird als Führungsgröße für die Regelung weiterer Komponenten des Kälteversorgungssystems benutzt. Dies wird im Zusammenhang mit Figur 6b erläutert.

Figur 6b zeigt, wie der aktuell maximal mögliche Sollwert der Zulufttemperatur als Sollwert für die Führung des Regelkreises RK4 verwendet wird. Der Regelkreis RK4 für die Vorlauf-Temperaturregelung der Wärmetauscher des Umluftkühlsystems ist beispielsweise als PID-Regler ausgeführt. Als Ausgangssignal wird die Variable Sollwert der Vorlauftemperatur für die Wärmetauscher den Regelkreisen RK1 und RK2 zur Verfügung gestellt. Je höher der aktuell maximal mögliche Sollwert der Zulufttemperatur ist, desto höher wird auch der Sollwert für die Vorlauftemperatur der Wärmetauscher sein.

Die Lüfter des Freikühlers 30 (Figur 1) werden bei steigender Außentemperatur bis auf 100 % Drehzahl gerichtet. Bei Zurückgehen der Temperaturdifferenz im Kühlmedium gegen Null, was bedeutet, dass der Vorlauf gleich warm ist wie der Rücklauf, und einer Lüfterdrehzahl von 100 %, wird der Freikühler 30 abgeworfen. Das Abwerfen dient dazu, eine Aufwärmung des aus dem Umluftkühlsystem zurückkehrenden Mediums im Sommerbetrieb auszuschließen.

Die jeweilige Abwurftemperatur, die der Außenlufttemperatur beim Auslösen des Abwurfs entspricht, wird gespeichert und zur Wiederinbetriebnahme des Freikühlers 30 verwendet. Der Freikühler 30 wird wieder in Betrieb genommen, wenn die Abwurftemperatur um einen Betrag ΔT, der frei parametrierbar ist, unterschritten wird. Neben dieser automatischen Inbetriebnahme ist eine manuelle Beeinflussung möglich, indem die Abwurftemperatur über eine Bedienoberfläche rückgesetzt wird oder auch über ein numerisches Eingabefeld manuell parametriert wird.

Die Lüfter des Freikühlers 30 werden bei sinkender Außentemperatur auf eine Mindestdrehzahl geregelt. Unterhalb der Mindestdrehzahl wird der Freikühler 30 verriegelt, um eine Unterkühlung des Mediums zu vermeiden. Die Mindestdrehzahl ist als Prozentsatz von 100 frei parametrierbar.

Der Freikühler 30 wird wieder in Betrieb genommen, wenn das Dreiwege-Regelventil 40 über einen Schwellwert im Durchgang vom Freikühler 30 geöffnet ist und die Vorlauftemperatur einen Schwellwert der Temperaturdifferenz über der Solltemperatur überschreitet. Dieser Schwellwert ist ebenfalls frei parametrierbar.

Die Startdrehzahl der Lüfter des Freikühlers 30 entspricht der Drehzahl bei der Verriegelung.

Der Regelkreis RK2 ist ebenfalls als PID-Regler ausgeführt. Führungsgröße ist die Vorlauftemperatur, die durch den Regelkreis RK6 bestimmt wird.

Das Dreiwege-Ventil 44 wird bei sinkender Außentemperatur auf 100 % Bypass geregelt. Da im Rechenzentrum permanent Wärme anfällt, wird eine Bypass-Öffnung zu 100 % in der Praxis nicht erreicht werden. Bei steigender Außentemperatur wird das Dreiwege-Ventil 44 auf 100 % Durchgang geregelt.

Wenn ein Schwellwert der Ventilöffnung im Durchgang vom Freikühler 30 erreicht wird, wird der Freikühler 30 freigegeben. Nach Freigabe des Freikühlers wird das Dreiwege-Ventil 44 in 100 %-Stellung im Durchgang vom Freikühler und wird verriegelt. Die Entriegelung erfolgt, wenn der Freikühler 30 wieder seine parametrierte Messdrehzahl erreicht hat.

Im Regelkreis RK3 erfolgt die Stetigregelung der Drehzahl der Pumpe für den Durchfluss des Kühlmediums zu den Wärmetauschern des Umluftkühlsystems abhängig vom berechneten Sollwert und von der vom Durchflussmesser 42 gemessenen Durchflussmenge wird die Drehzahl der Pumpe stetig verändert. Der Sollwert der Fördermenge entspricht der Nennmedienmenge der Wärmetauscher und wird durch den Regelkreis RK5 beeinflusst.

Die Aufgabe des Regelkreises RK5 ist es, die mögliche Förderleistung der Pumpe optimal auszunutzen. Die Erhöhung des Mediendurchsatzes führt zu einer Leistungssteigerung des Wärmetauschers des Freikühlers 30 und der Wärmetauscher des Umluftkühlsystems und damit zu einer Erhöhung der Freikühl-Grenztemperatur.

Bei Anstieg der Drehzahl der Pumpe im Freikühler 30 über einen parametrierbaren Schwellwert, z. B. 95 %, hinaus wird die Drehzahl der Förderpumpe stetig angehoben, bis ein Schwellwert der elektrischen Leistungsaufnahme der Pumpe erreicht ist. Die Leistungsaufnahme steigt ab einem bestimmten Wert entsprechend einer Exponentialfunktion steil an. Der Schwellwert wird deshalb iterativ aus der Kurve der Leistungsaufnahme ermittelt und manuell parametriert.

Das Abfallen der Lüfterdrehzahl des Freikühlers 30 bei sinkender Außentemperatur wird erfasst und dazu genutzt, den Sollwert der Fördermenge wieder abzusenken, bis die Nennmedienmenge erreicht ist. Auch bei Abwurf des Freikühlers 30 wird der Sollwert der Fördermenge wieder auf die Nennmedienmenge gesetzt.

Auch der Regelkreis RK5 ist als PID-Regler ausgeführt. Führungsgrößen sind die Messung der Ist-Wassermenge durch den Durchflussmesser 42, der Messwert der elektrischen Leistungsaufnahme der Pumpe sowie die Drehzahl des EC-Lüfters des Freikühlers 30.

Zur Bewertung der Effizienz der in Rechenzentren eingesetzten Energie wird als Kennwert die Power Usage Effectiveness PUE verwendet. Der PUE-Wert setzt die insgesamt im Rechenzentrum verbrauchte Energie ins Verhältnis zu der Energieaufnahme der Hardware. Wenn sich dieses Verhältnis der Zahl 1 nähert, ist sichergestellt, dass das Rechenzentrum effizient arbeitet. Mit der Erfindung können PUE-Werte von 1,3 und darunter erreicht werden.

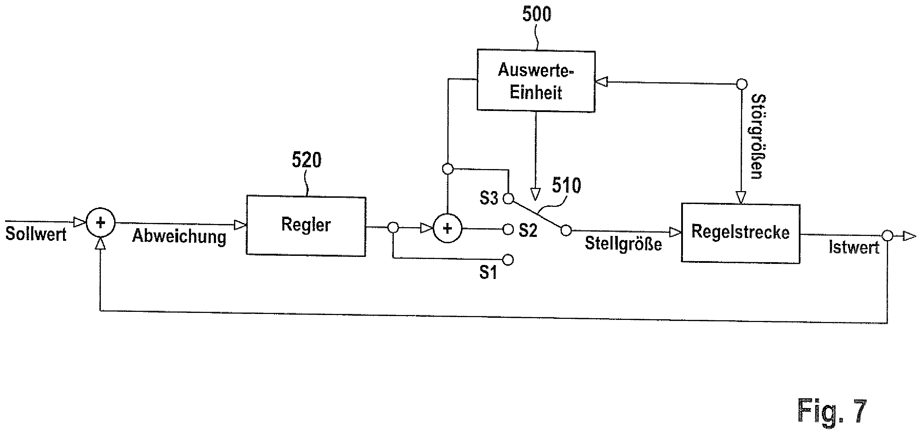

Figur 7 zeigt eine schematische Darstellung der Klimaregelung nach dem zweiten Aspekt der Erfindung. In der Figur 7 bedeutet

| | |
|---|---|
| Sollwert: | vom Anwender konfigurierbarer Temperatur-Sollwert für Klimatisierung |
| Abweichung: | Differenz von Sollwert und aktueller Temperatur |
| Stellgröße: | Vorgabe für Leistung der Klimatisierungsmaßnahme |
| Störgrößen: | weitere Einflussgrößen auf die Temperatur (z. B. Verlustleistung, Einstrahlung) |
| Istwert: | aktuelle Temperatur |

Eine Auswerte-Einheit 500 verfügt über physikalische Eingangs-Schnittstellen zur Aufnahme von Sensordaten zur Bestimmung ursächlicher Einflussgrößen auf den Klimatisierungsbedarf und kann anhand von aufgenommenen Messwerten den Klimatisierungsbedarf abschätzen, so dass der Regelung der Klimatisierungsmaßnahmen eine Stellgröße direkt vorgegeben werden kann oder ergänzende Einflussgrößen zur Ermittlung der Stellgröße zur Verfügung gestellt werden können. Die Auswerte-Einheit ermöglicht so eine bedarfsgerechtere, schnellere und genauere Regelung der Klimatisierungsmaßnahme. Durch die Möglichkeit der bedarfsgerechteren Regelung kann ebenso die Energieeffizienz der Klimatisierungsmaßnahmen verbessert werden. Die Auswerte-Einheit kann als eigenständiges System realisiert werden oder als Teilfunktion in die Steuerung eines Klimatisierungsgeräts integriert werden.

Die Auswerte-Einheit 500 prüft in regelmäßigen oder unregelmäßigen Abständen, ob an ihren Eingangs-Schnittstellen Messdaten zur Verfügung stehen, die Aufschluss über die aktuell wirksamen Störgrößen geben.

Stehen keine gültigen Messwerte zur Verfügung, wird der Ausgang des Reglers 520 als Stellgröße verwendet. Das entspricht einer klassischen Temperaturregelung ohne Einfluss einer übergeordneten Auswerte-Einheit und der Schalterstellung S1 des Schalters 510 in der Figur 6.

Stehen ausreichend Messwerte zur Verfügung, um abzuleiten, dass bei entsprechender Einstellung der Stellgröße eine Überschreitung des vorgegebenen Sollwerts durch die aktuelle Temperatur nicht möglich ist, wird als Stellgröße ein aus Konditionierung der Messwerte gewonnener Wert verwendet. Das entspricht einer direkten Steuerung der Klimatisierungsmaßnahme durch die Auswerte-Einheit 500 ohne geschlossenen Regelkreis, also Schalterstellung S3 des Schalters 510.

Stehen Messwerte zur Verfügung, die jedoch nicht ausreichen, um durch direkte Vorgabe der Stellgröße eine Nicht-Überschreitung des Sollwerts zu garantieren, wird der Ausgang des Reglers 520 mit einem aus Konditionierung der Messwerte gewonnene Korrektur-Wert beaufschlagt, was der Schalterstellung S2 des Schalters 510 entspricht.

Zur Konditionierung der gemessenen Parameterwerte sind unter anderem Überprüfung der einzelnen Messgrößen auf ihren jeweils gültigen Wertebereich, Mittelwertbildung von einzelnen Messgrößen, Verstärkung von einzelnen Messgrößen, Addition von einzelnen Messwerten zu einem Ausgangswert, Offsetverschiebung des Ausgangswerts und Begrenzung des Ausgangswerts auf Minium- und Maximum-Werte vorgesehen.

Die Auswerte-Einheit weist Anschlussmöglichkeiten für mehrere Sensoren auf, die vom Anwender optional eingesetzt werden können. So ist es für den Anwender möglich, die Optimierungsmöglichkeiten nicht zu nutzen, sie zur teilweisen Optimierung der Regelung zu nutzen oder die Regelung vollständig zu ersetzen.

Die Entscheidung, für welchen Fall die verfügbaren Messwerte ausreichen, wird anhand von Regeln getroffen, die durch Experten eingestellt werden können. In den Regeln ist hinterlegt, welche Störgrößen durch gültige Messdaten bekannt sein müssen, um auf eine durch die Auswerte-Einheit beeinflusste Stellgröße umzuschalten. Ebenfalls durch Experten einstellbar sind die Bedingungen, die für die Konditionierung der Messwerte genutzt werden.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

## Patentansprüche

1. Verfahren zum Klimatisieren einer IT-Umgebung, die als wärmeerzeugende Hardware IT-Geräte, Rechner, Speicher, Telekommunikationsgeräte und Peripheriegeräte umfasst, wobei in einem Kälteversorgungssystem Freikühler, Kältemaschinen und ein mit Lüftern betriebenes und Wärmetauscher enthaltendes Umluftsystem zum Abführen der von der Hardware erzeugten Wärme vorhanden sind;
mit den Schritten:
- Klimatisieren der IT-Umgebung mit dem Kälteversorgungssystem, das der IT-Umgebung über das Umluftsystem Luft mit einer Zulufttemperatur zuführt;
- Festlegen eines Basis-Sollwertes für die Zulufttemperatur zur IT-Umgebung aufgrund der bestehenden Hardware-Konfiguration;
- ständiges Messen der elektrischen Leistungsaufnahme der Hardware und Speichern eines dabei jeweils gemessenen Wertes; und
- Ermitteln eines Sollwertes für die Zulufttemperatur aus dem gemessenen Wert für die elektrische Leistungsaufnahme der Hardware,
**gekennzeichnet durch** die weiteren Schritte:
- Anheben des Basis-Sollwertes für die Zulufttemperatur, solange keine Änderung des Wertes für die elektrische Leistungsaufnahme der Hardware ermittelt wird, dann,
- bei Detektion eines Anstiegs des Wertes für die elektrische Leistungsaufnahme der Hardware auf einen kritischen Wert, Absenken des angehobenen Basis-Sollwertes für die Zulufttemperatur, bis der gespeicherte Wert wieder erreicht ist; und
- wenn der gespeicherte Wert innerhalb einer zuvor festgelegten Zeitdauer nicht erreicht wird, Rücksetzen des Sollwertes für die Zulufttemperatur auf den Basis-Sollwert.

2. Verfahren nach Anspruch 1, weiter mit den Schritten:
- Messen der Zulufttemperatur zur Hardware;
- Messen der Rücklufttemperatur von der Hardware;
- Ermitteln des Sollwertes der Drehzahl für die Lüfter des Umluftsystems mit der Zulufttemperatur und der Rücklufttemperatur als Parameter;
- Messen des Istwertes der Drehzahl der Lüfter des Umluftsystems;
- Erhöhen oder Erniedrigen der Drehzahl, um Sollwert und Istwert aneinander anzugleichen, so dass ein aktualisierter Istwert erhalten wird;

3. Verfahren nach Anspruch 1, bei dem alle Lüfter des Umluftsystems parallel mit einem Signal angesteuert werden.

4. Verfahren nach Anspruch 1, weiter mit dem Schritt:
- Ermitteln des Sollwertes der Vorlauftemperatur der Wärmetauscher aus dem Istwert der Zulufttemperatur.

5. Verfahren nach Anspruch 4, bei dem die Vorlauftemperatur der Wärmetauscher als Stellgröße für die Drehzahl der Lüfter des Freikühlers verwendet wird.

6. Verfahren nach Anspruch 1, bei dem in regelmäßigen oder unregelmäßigen Abständen geprüft wird, ob gemessene Parameterwerte zur Verfügung stehen, die mit aktuell wirkenden Störgrößen zu korrelieren sind.

7. Verfahren nach Anspruch 6, bei dem die gemessenen Parameterwerte konditioniert werden und der konditionierte Wert die Stellgröße der Regelung bestimmt.

## Claims

1. A method for air conditioning an IT environment including, as heat generating hardware, IT devices, computers, memories, telecommunication devices and peripheral devices, wherein, in a refrigeration supply system, free coolers, refrigerators and an air circulation system operated with fans and containing heat exchangers for drawing off the heat generated by the hardware are provided; comprising:
- air conditioning an IT environment with the refrigeration supply system which supplies air with a feed air temperature to the IT environment via the air circulation system;
- determining a basic desired value for the feed air temperature to the IT environment on the basis of the existing hardware configuration;
- continuously measuring the electrical power consumption of the hardware and memories and storing a respective value measured in the process;
- determining a desired value for the feed air temperature from the measured value for the electrical power consumption of the hardware,
**characterized in that**
- raising the desired value for the feed air temperature as long as no change of the value of the electrical power consumption of the hardware has been detected, then,
- in the case of detection of an increase of the value for the electrical power consumption of the hardware towards a critical value, lowering of the raised basic desired value for the feed air temperature until the stored value is reached again; and
- if the stored value is not reached within a previously defined time period, resetting of the desired value for the feed air temperature to the basic desired value.

2. The method according to claim 1, further comprising:
- measuring the feed air temperature toward the hardware;
- measuring the return air temperature from the hardware;
- determining the desired value of the rotation speed for the fans of the air circulation system with the feed air temperature and the return air temperature as parameters;
- measuring the actual value of the rotation speed of the fans of the air circulation system;
- increasing or lowering the rotation speed in order to match the desired value and the actual value to one another, so that an updated actual value is obtained.

3. The method according to claim 1, wherein all the fans of the air circulation system are controlled in parallel with one signal.

4. The method according to claim 1, further comprising:
- determining the desired value of the feed flow temperature of the heat exchangers from the actual value of the feed air temperature.

5. The method according to claim 4, wherein the feed flow temperature of the heat exchangers is used as setting variable for the rotation speed of the fans of the free cooler.

6. The method according to claim 1, wherein a verification is carried out at regular or irregular intervals in order to determine whether measured parameter values that correlate with currently acting disturbance variables are available.

7. The method according to claim 6, wherein the measured parameter values are conditioned and the conditioned value determines the setting variable of the feedback control.

## Revendications

1. Procédé de climatisation d'un environnement informatique qui comprend, en tant que matériel produisant de la chaleur, des appareils informatiques, des calculateurs, des mémoires, des appareils de télécommunication et des appareils périphériques, dans lequel, dans un système de réfrigération, on trouve des modules de refroidissement naturel, des machines frigorifiques et un système de circulation d'air fonctionnant avec des ventilateurs et contenant un échangeur de chaleur pour l'évacuation de la chaleur produite par le matériel ;
avec les étapes suivantes:
- climatisation de l'environnement informatique avec le système de réfrigération qui conduit à l'environnement informatique, par le biais du système de circulation d'air, de l'air à une température d'amenée d'air ;
- spécification d'une valeur de consigne de base pour la température d'amenée d'air destinée à l'environnement informatique sur la base de la configuration matérielle existante ;
- mesure continue de la puissance électrique absorbée du matériel et enregistrement d'une valeur mesurée respectivement à cette occasion et
- détermination d'une valeur de consigne pour la température d'amenée d'air à partir de la valeur mesurée de la puissance électrique absorbée du matériel,
**caractérisé par** les autres étapes suivantes :
- relèvement de la valeur de consigne de base pour la température d'amenée d'air tant qu'aucune variation de la valeur de la puissance électrique absorbée du matériel n'est déterminée puis,
- lors de la détection d'une augmentation de la valeur de la puissance électrique absorbée du matériel jusqu'à une valeur critique, abaissement de la valeur de consigne de base relevée pour la température d'amenée d'air jusqu'à ce que la valeur enregistrée soit de nouveau atteinte ; et
- si la valeur enregistrée n'est pas atteinte à l'intérieur d'une durée spécifiée au préalable, la valeur de consigne pour la température d'amenée d'air est ramenée à la valeur de consigne de base.

2. Procédé selon la revendication 1, également avec les étapes suivantes :
- mesure de la température d'amenée d'air vers le matériel ;
- mesure de la température de retour en provenance du matériel ;
- détermination de la valeur de consigne pour la vitesse de rotation pour les ventilateurs du système de circulation d'air, avec la température d'amenée d'air et la température d'air de retour en tant que paramètres ;
- mesure de la valeur effective de la vitesse de rotation des ventilateurs du système de circulation d'air ;
- augmentation ou abaissement de la vitesse de rotation pour harmoniser entre elles la valeur de consigne et la valeur effective de sorte qu'une valeur effective actualisée est obtenue.

3. Procédé selon la revendication 1, dans lequel tous les ventilateurs du système de circulation d'air sont commandés en parallèle avec un signal.

4. Procédé selon la revendication 1, également avec l'étape suivante :
- détermination de la valeur de consigne pour la température aller des échangeurs de chaleur à partir de la valeur effective de la température d'amenée d'air.

5. Procédé selon la revendication 4, dans lequel la température aller des échangeurs de chaleur est utilisée en tant que grandeur réglante pour la vitesse de rotation des ventilateurs du module de refroidissement naturel.

6. Procédé selon la revendication 1, dans lequel, à des intervalles réguliers ou irréguliers, il est contrôlé si des valeurs de paramètres mesurées sont disponibles, qui doivent être corrélées avec des grandeurs perturbatrices qui agissent actuellement.

7. Procédé selon la revendication 6, dans lequel les valeurs de paramètres mesurées sont conditionnées, et la valeur conditionnée définit la grandeur réglante de la régulation.
